# EUROPEAN PATENT SPECIFICATION

(11) **EP 1 196 789 B1**
(45) Date of publication and mention of the grant of the patent: **01.03.2006**
(21) Application number: 99925938.5
(22) Date of filing: 27.05.1999
(51) Int. Cl.: G01R 31/307, G01R 31/311, G01R 31/28

(54) **USE OF CONVERGING BEAMS FOR TRANSMITTING ELECTROMAGNETIC ENERGY TO POWER DEVICES FOR DIE TESTING**
ANWENDUNG VON KONVERGIERENDEN STRAHLEN ZUM ÜBERTRAGEN VON ELEKTROMAGNETISCHER ENERGIE AN LEISTUNGSANORDNUNGEN ZUM TESTEN VON CHIPS
UTILISATION DE FAISCEAUX CONVERGENTS DESTINES A EMETTRE DE L'ENERGIE ELECTROMAGNETIQUE VERS DES DISPOSITIFS DE PUISSANCE POUR TESTER DES PUCES

(43) Date of publication of application: 17.04.2002
(73) Proprietor: Conexant Systems, Inc., Newport Beach, California 92660-3095 (US)
(72) Inventor: WHITE, Stanley, A., San Clemente, CA 92672 (US); WALLEY, Kenneth, S., Portola Hills, CA 91679 (US); JOHNSTON, James, W., Rancho Santa Margarita, CA 92688 (US); HENDERSON, P., Michael, Tustin, CA 92782 (US); ANDREWS, Warner, B., Jr., Boulder, CO 80302 (US); SIANN, Jonathan, I., San Diego, CA 92129 (US); HALE, Kelly, H., Aliso Viejo, CA 92656 (US)
(74) Representative: Rehberg Hüppe + Partner
(86) International application number: PCT/US1999/011752
(87) International publication number: WO 2000/073808

(56) References cited:
- US-A- 4 851 768
- PATENT ABSTRACTS OF JAPAN vol. 017, no. 199 (E-1352), 19 April 1993 (1993-04-19) & JP 04 343245 A (MITSUBISHI ELECTRIC CORP), 30 November 1992 (1992-11-30)

## Description

### BACKGROUND OF THE INVENTION

The present invention relates to testing individual integrated circuits. In particular, the present invention relates to selectively testing individual chips on a wafer containing multiple chips.

Integrated circuits, and in particular semiconductor integrated circuits, are manufactured by fabricating several individual dies or chips on a wafer. The dies on a single wafer are typically identical. After fabrication, the wafer is cut up into the individual dies. The process of cutting or sawing the wafer into the individual dies is called "dicing" the wafer. After the wafer is diced, the individual dies are then packaged.

Before the wafer is cut into the individual dies, the manufacturer may desire to test the individual dies. Such testing permits the manufacturer to discard non-functional die(s) prior to incurring the expense of packaging such defective dies.

Typically the individual dies are tested by contacting each die on the wafer with a probe device. The probe device contacts test contact pads fabricated on each die, activates the circuitry on the die, and executes a test of the chip. The dies failing the test are marked, and are discarded after the wafer is diced.

U.S. Patent 4,851,768 an apparatus and a method of wirelessly applying voltages to select locations on an electronic device wherein a plurality of discloses voltage supply beams are used to irridiate respective locations on an electronic device.

The current testing methods require that physical probes must be designed and prepared for each different die design, as the points at which the probes must contact the die are different for each die design: The different designs additionally require that the chip tester be physically reconfigured each time a different die design is to be tested.

### SUMMARY OF THE INVENTION

The present invention is a method for wirelessly testing an individual die on a wafer containing multiple indinvidual dies or integrated circuits.

The method of testing incorporates selectively activating a selected die on the wafer. The die may be activated by being impacted by electromagnetic energy having at least a first energy level. The method of activating the selected die according to claim 1 includes directing first and second beams of electromagnetic energy toward the die. Each of the first and second beams of electromagnetic energy individually has less than the first energy level required to activate the die. The method further includes directing the first and second beams of the electromagnetic energy so that they at least partially overlap on the die. The first and second beams overlap on the selected die in a region of overlap. In the region of overlap, the first and second beams impact the die with an energy level greater than the first energy level required to activate the die.

The method may additionally include detecting electromagnetic radiation radiated by the die when the die is activated by the energy of the first and second beams of electromagnetic energy. Another method for activating the selected die according to claim 7 includes directing first, second and third beams of electromagnetic energy towards the die, wherein the beams overlap on the selected die and impact the die with an energy level greater than the first energy level required to activate the selected die.

### BRIEF DESCRIPTION OF THE DRAWINGS.

Figure 1 illustrates a semiconductor wafer containing a plurality of individual dies that may be tested in accordance with the present invention.
Figure 2 is a representation of the layout of an individual die of the wafer shown in Figure 1.
Figure 3 is a diagrammatic representation of a portion of the circuitry of the die shown in Figure 2.
Figure 4 is a schematic diagram of a portion of the circuitry of the die shown in Figure 2.
Figure 5 is a representation of the layout of an alternative embodiment of an individual die of the wafer shown in Figure 1.
Figure 6 is a diagrammatic representation of a portion of the circuitry of the die shown in Figure 5.
Figure 7 is a representation of the layout of another embodiment of an individual die of the wafer shown in Figure 1.
Figure 8 is an enlarged plan view of a portion of the layout of the die shown in Figure 7.
Figure 9 is a cross sectional view taken along line 9 - 9 of Figure 8.
Figure 10 is a cross sectional view taken along line 10 -10 of Figure 8.
Figure 11 is a diagrammatic representation, of a portion of one embodiment of the radio-frequency radiating element portion of the circuitry of the die shown in Figures 2, 5, and 7.
Figures 12a and 12b are schematic diagrams of alternative embodiments of the radiating element portions of the circuitry of the die shown in Figures 2, 5, and 7.
Figure 13 illustrates a test apparatus constructed. for use in acordance with the method of the present invention.
Figure 14 shows a wafer of individual integrated circuits with the overlapping beams of electromagnetic energy applied by the apparatus of Figure 13.
Figure 15 is a simplified diagram, partially in cross-section, of a source of electron beams in accordance with an aspect of an embodiment of the present invention.
Figure 16 is a simplified diagram, partially in cross-section, of a source of electron beams in accordance with an aspect of another embodiment of the system for using the present invention.
Figure 17 is a simplified diagram, partially in cross-section, of a source of radio frequency energy in accordance with an aspect of yet another embodiment of the system for using the present invention.
Figure 18 is a simplified diagram of a source of radio frequency energy.
Figure 19 is a perspective view of a test apparatus probe.
Figure 20 is a schematic diagram of a receiver incorporated in the test probe shown in Figure 19.

### DETAILED DESCRIPTION OF A PREFERRED EMBODIMENT

Semiconductor integrated circuits are typically formed by fabricating a wafer containing several individual integrated circuits, or dies. Typically, all the dies on a single wafer are identical.

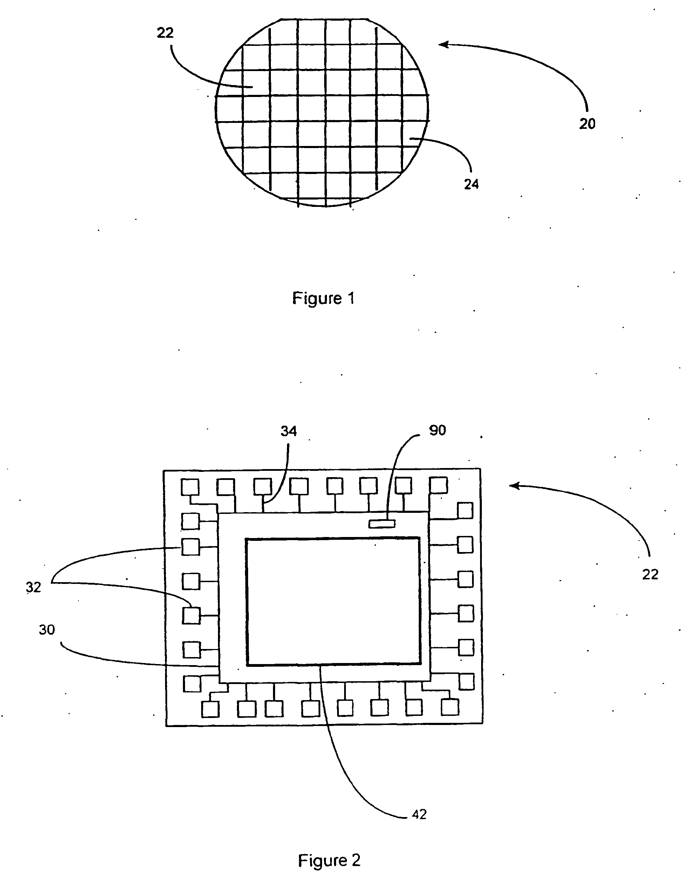

A representative wafer 20 containing several individual dies is shown in Figure 1. A particular die 22 is identified. All the other dies on the wafer 20 are identical to dies die 22. The wafer 20 may contain some partial dies 24 at the edges of the wafer 20. Many techniques for fabricating such wafers are generally known and available in the semiconductor manufacturing arts.

After the wafer 20 is fabricated, preliminary testing is performed on die 22 of the wafer. After such testing, the individual dies are sawed apart, or diced. The process of dicing semiconductor wafers into the individual dies is well understood in the art. Each separate individual die 22 may then be packaged using any of the conventionally available packaging techniques.

A representation of one embodiment of the individual die 22 is shown in Figure 2. The die 22 includes primary circuitry 30 surrounded by a plurality of contact pads 32. When packaging the die, the contact pads 32 are the points at which the wires of the package pins contact the circuitry on the die. Each contact pad 32 is connected to the primary die circuitry 30 by a conductive trace or lead 34.

The contact pads 32 may also be used in testing the die 22, either while the die 22 is still part of the wafer 20; or after the wafer 20 is diced into the individual dies. Test probes may be brought into contact with appropriate ones of the contact pads 32 to activate the circuitry 30, and to check for particular responses from the circuitry 30.

In accordance with the present invention, the individual die 22 is also activated wirelessly, without physical contact between a test probe and the die 22. In accordance with the present invention, the die 22 may is powered or activated by directing electromagnetic energy onto the die 22. If the electromagnetic energy impacting the die 22 exceeds a predetermined first energy level, the circuitry 30 of the die 22 is activated. The predetermined first energy level is the energy level that is sufficient to activate the die 22.

One or more conductor loops 42 formed in the circuitry 30 of the die 22. The conductor loop 42 forms an inductor when a changing electromagnetic energy passes over the conductor loop 42, so that a voltage is generated in the conductor loop 42.

As will be recognized and understood by those skilled in the art, a moving electrical charge (a current) generates a magnetic field. A moving magnetic field generates an electric field having a voltage, which can give rise to an electrical current. This pair of phenomena allows radiated electromagnetic energy that impacts or passes through the conductor loop 42 to generate a current in the conductor loop 42.

lf the electromagnetic energy passing through the conductor loop 42 exceeds a predetermined activation level, sufficient voltage is generated in the conductor loop 42 to power or activate the circuitry 30, or at least a particular portion of the circuitry 30 that is of interest.

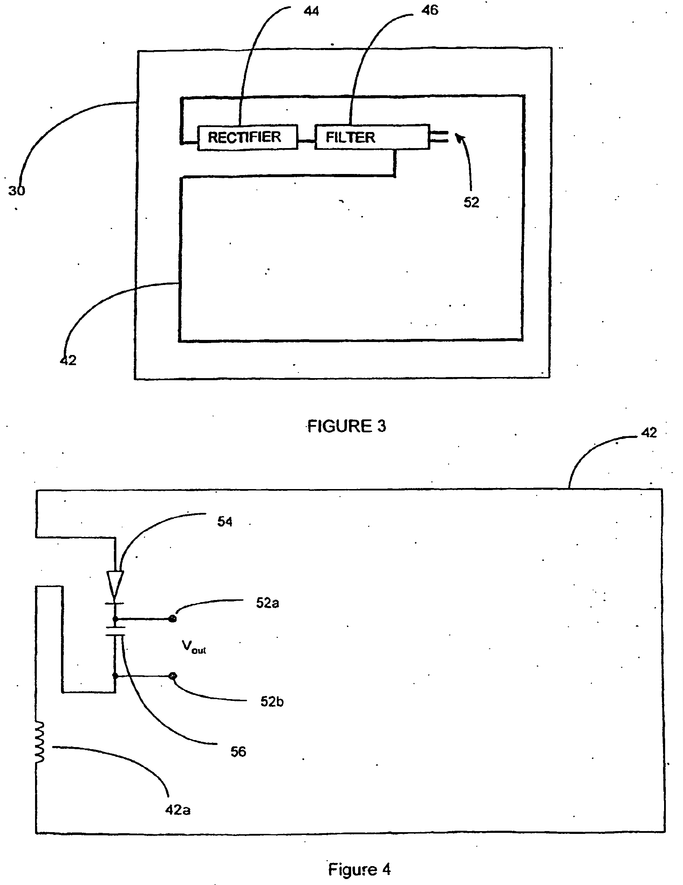

As shown in Figure 3, the circuitry that includes the conductor loop 42 additionally includes a rectifier 44 and a filter 46 to provide the electrical power to energize the remainder of the circuitry 30 on the die 22. Electromagnetic energy passing through the conductor loop 42 generates a voltage at the output 52 of the filter 46 that may be used to drive the remainder of the circuitry 30.

A very simple rectifier and filter structure is shown in Figure 4. The rectifier and filter circuit includes a diode 54 and a capacitor 56. Output terminals 52a, 52b are connected across the capacitor 56. The inductance of the loop 42 is indicated schematically at 42a.

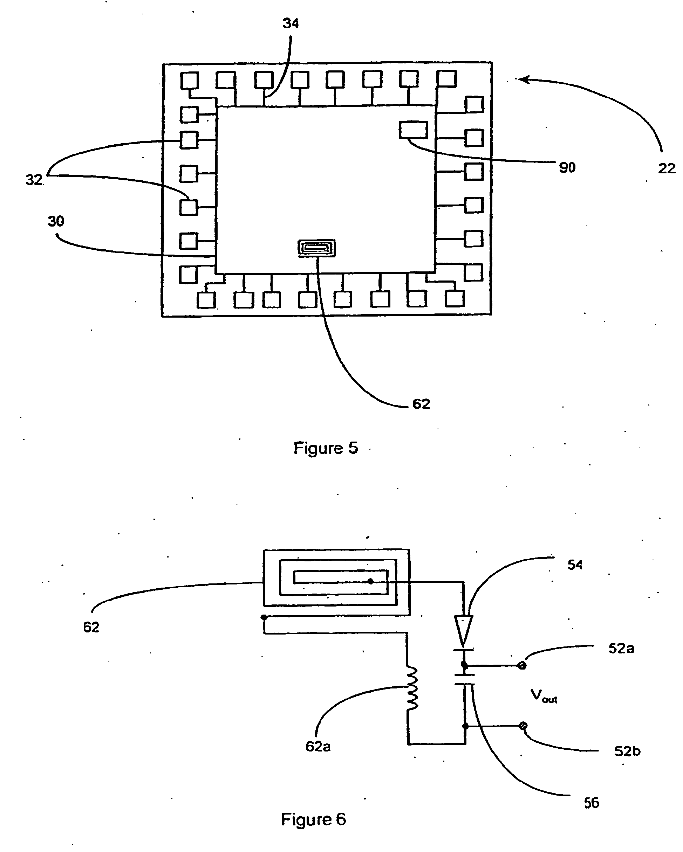

An alternative arrangement of the conductor loop is shown in Figure 5. In lieu of a single conductor loop extending around a substantial portion of the circuitry 30, a spiral loop 62 is included in a portion of the circuitry 30. The spiral loop 62 may be formed as a continuous conductor on a single layer of the die 22. Referring to Figure 6, a simple rectifier 54 and filter 56 are shown coupled to the spiral loop 62. The rectifier and filter shown in Figure 6 are the same as those shown in Figure 4. The inductance of the spiral loop 62 is indicated schematically at 62a.

Those skilled in the art will recognize that as the changing electromagnetic field passes over the spiral conductor 62, a voltage is-created between the ends of the spiral conductor 62. The voltage created between the ends of the spiral conductor 62 is proportional to the number of turns in the spiral 62. The voltage created in the spiral 62 causes a current to flow through the diode 54 and the capacitor 56, which in turn produces a voltage at the output terminals 52a, 52b. The voltage at the output terminals 52a, 52b may then be used to drive the remainder of the circuitry 30. Particular requirements may require that a greater or lesser number of turns be included in the spiral conductor 62.

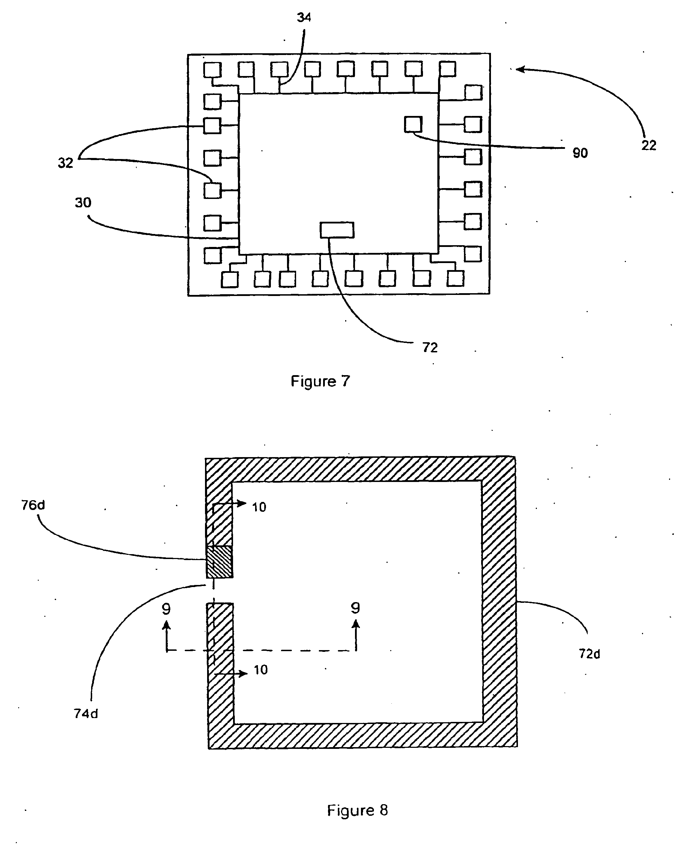

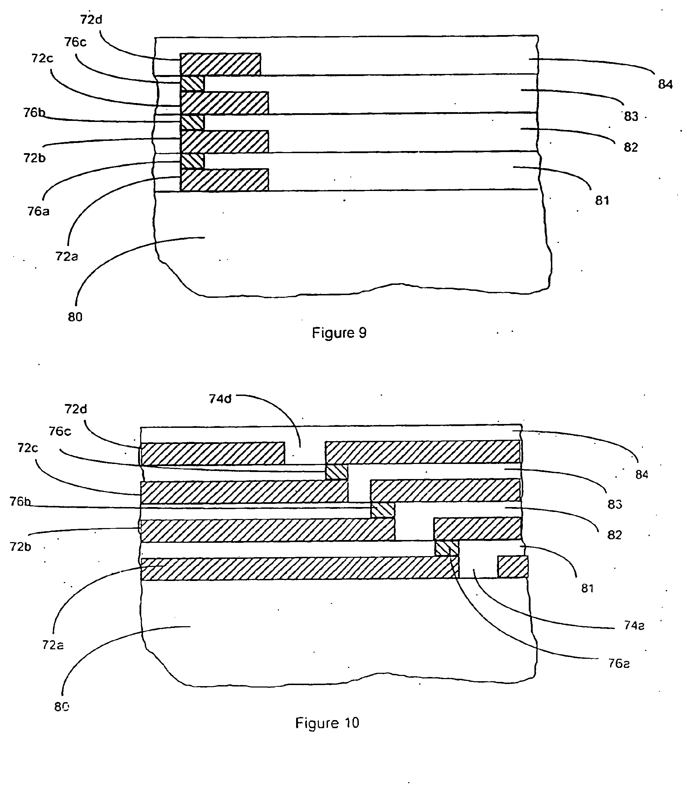

Yet another embodiment or arrangement for the conductor loop is shown in Figures 7, 8, 9, and 10. The conductor loop 72 shown in Figure 7 is a multi-layer conductor spiral. The conductor loop 72 is formed of several layers of individual loop layers 72a-d (see Figures 9 and 10). The top conductor loop layer 72d is shown in Figure 8 as representative of the individual loop layers. Referring now to Figure 8, the top conductor loop layer 72d is not quite a complete loop. The top conductor loop layer 72d has a gap 74 between the ends of the conductor of the loop layer 72d. The first, second, and third conductor loop layers 72a, 72b, 72c are similar to the top conductor loop layer 72d shown in Figure 8. Thus, each conductor loop layer 72a, 72b, 72c, 72d forms almost one complete turn of the vertical conductor spiral.

Referring to the cross-sectional view of Figure 9, the spiral loop 72 includes several conductor loop layers 72a, 72b, 72c, 72d. Each conductor loop layer 72a. 72b, 72c, 72d is formed in a corresponding layer 81, 82, 83, 84 of the semiconductor device which is fabricated on a substrate 80. The layers 81 - 84 are the layers in which the electronic circuitry 30 are formed on the die 22.

Inter-layer connectors 76a, 76b, 76c provide electrical conductivity between the conductor loop layers 72a, 72b, 72c, 72d. A first inter-layer connector 76a provides electrical conductivity between the conductor loop, portion 72a of the first layer 81 and the conductor loop portion 72b of the second layer 82. As seen in Figures 9 and 10, additional inter-layer connectors 76b. 76c provide electrical conductivity between the conductor loop portions 72b, 72c, 72d of the second, third, and fourth layers 82, 83, 84 of the die 22. The top inter-layer connector 76c connects the top loop layer 72d to the loop layer underneath it. Although shown in the view of Figure 8 to aid in understanding the structure, the interlayer connector 76c is actually beneath the top loop layer 72d, as is shown in Figures 9 and 10.

The conductor loop layers 72a, 72b, 72c, and 72d .are arranged above one another in the layers 81 - 84 so that together they form a vertical spiral of conductive material through the layers 81 - 84 of the semiconductor die 22. The gaps in each conductor layer are staggered, as shown in Figure 10, so that the conductor layers 72a - 72d form a spiral. A rectifier and filter such as that shown in Figures 4 and 6 may be coupled between the two ends of the multi-layer spiral conductor ioop.

As is recognized by those skilled in the art, when electromagnetic energy or radiation impacts the vertical spiral conductor 72, a voltage is created between the two ends of the conductor spiral. This voltage is proportional to the number of turns in the conductor spiral loop 72. The voltage created between the two ends of the conductor spiral loop 72 creates a current that may be used to drive the circuitry 30.

As shown in Figures 2. 5, and 7, the circuitry 30. on the die 22 additionally includes an electromagnetic transmitter or radiating element 90. The radiating element 90 provides a wireless response signal when the circuitry 30 of the die 22 is activated. The response signal emitted by the radiating element 90 indicates the status of the die 22. The circuitry 30 of the die 22 is designed so that when the die is activated, the radiating element 90 emits an electromagnetic signal representative of the status of the die 22. As described above, the die 22 may be activated by electromagnetic energy passing over the conductor loop 42 (Figure 2), 62 (Figure 5), or 72 (Figure 7).

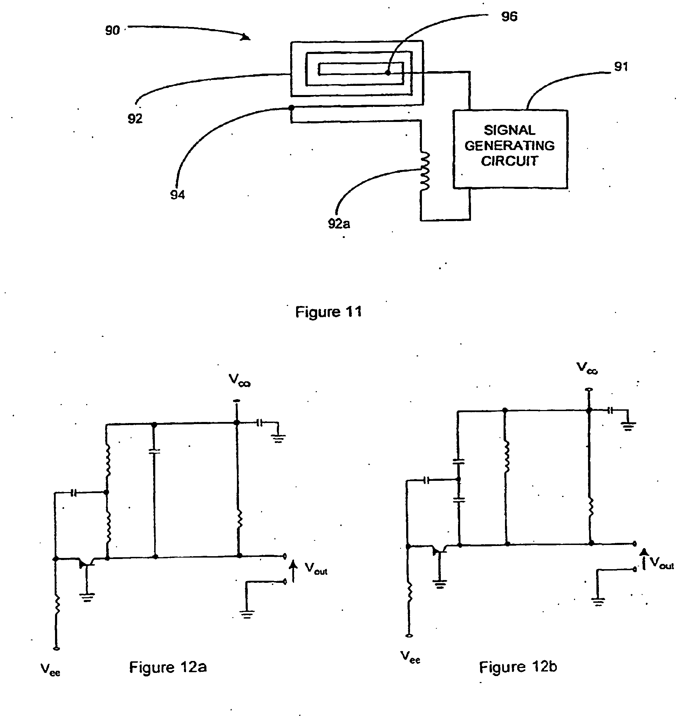

The electromagnetic radiating element 90 may include a second conductor loop through which the circuitry 30 may direct a current when the die 22 is activated. The conductor loop of the electromagnetic radiating element 90 may be a spiral loop 92 (Figure 11). When the circuitry 30 is activated by a current flowing through the first, activation conductor loop 42 (Figure 2), 62 (Figure 5), or 72 (Figure 7), a signal generating circuit 91 in the circuitry 30 causes a voltage to be applied across the terminals 94, 96 of the radiating element conductor loop 92, and a current to flow through the radiating element conductor loop 92. That current creates a magnetic field that radiates from the die 22 because of the inductance in the spiral loop 92. That inductance is indicated at 92a.

In certain applications, it may be possible for the activation conductor loop 42 (Figure 2) and, 62 (Figure 5), or 72 (Figure 7) to also serve as the radiating element 90. Those skilled in the art will recognize that in such a circumstance, additional components are required to provide the RF choke action to keep the output signal energy from the rectifier 44 (Figures 3 and 4).

In certain applications, more sophisticated information may be transmitted by the radiating element 90. information may be encoded onto electromagnetic radiation that is wirelessly transmitted by the radiating element 90. For example, the radiating element 90 may include a transmitting oscillator circuit for modulating the information onto a radio-frequency (RF) carrier. An NPN Hartley oscillator as shown in Figure 12a may be used for this purpose. Alternatively, an NPN Colpitts oscillator as shown in Figure 12b may be used. The Hartley and Colpitts oscillators, as well as other oscillators that may also be incorporated in the radiating element 90, are well understood in the art.

The oscillator of the radiating element 90 allows electrical information in the circuitry 30 to be modulated onto a radio-frequency (RF) carrier wave. The modulation may be frequency modulation or spread spectrum encoding.

Those skilled in the art will recognize that other methods of wirelessly transmitting information may be used in the radiating element 90. For example, infrared radiation may be used to carry the information. An on-chip infrared generator (not shown) in the radiating element 90 may be used to encode information onto an infrared beam. Yet further embodiments may incorporate one or more on-chip lasers (not shown) to transmit information. The information is modulated or encoded onto a beam of coherent optical radiation (light) emitted by the on-chip laser.

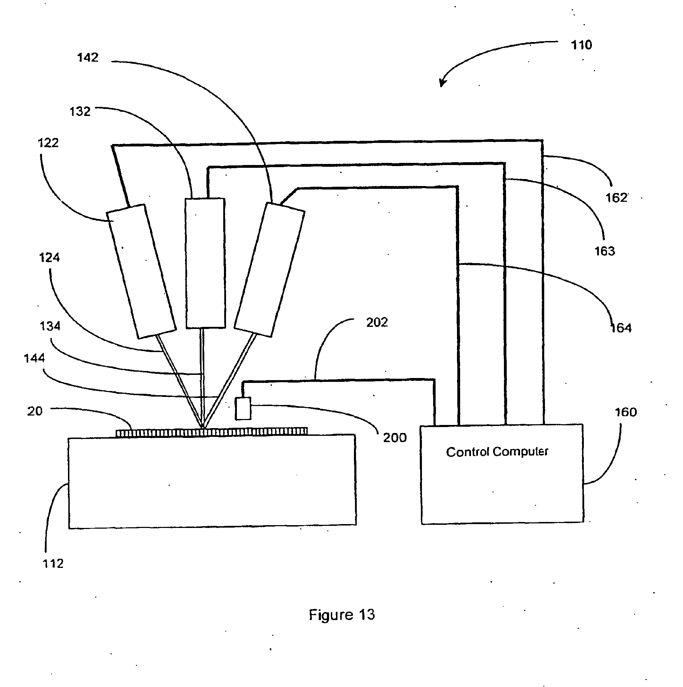

Referring now to Figure 13; a test system 110 that illustrates methods for wirelessly activating a selected die on a wafer is shown. The test system 110 includes a test bed 112 or other wafer support structure for supporting the wafer 20 containing the dies 22 that are to be tested.

The test system 110 includes .three sources of electromagnetic energy 122, 132, 142. Each of the electromagnetic energy sources 122, 132, 142 produces a narrow beam 124, 134, 144 of electromagnetic energy. The sources 122, 132. 142. direct those beams 124, 134. 144 toward the selected die 22 on the wafer 20 mounted on the test bed 112. Thus, the beams 124, 134, 144 converge on the selected die 22.

As described above, the die 22 may be activated by directing electromagnetic energy over the conductor loop 42 (Figure 2). 62 (Figure 5); or 72 (Figure 7). The die 22 is activated when the energy passing over or impacting the conductor loop 42, 62, or 72 exceeds a predetermined activation level.

A challenge to wirelessly activating the die 22 using beams of electromagnetic energy is to activate only one die at a time, so that each die may be individually tested.

Each die on the wafer may be provided with an individual address. The beams of electromagnetic energy may include coding related to those addresses. However, manufacturing individual addresses into each die on the wafer would require that different masks be used for each die on the wafer. Since semiconductor wafers are currently manufactured using identical masks for all the dies on the wafer, using different masks for each die on the wafer would substantially complicate the manufacturing process.

In many instances, it is difficult to accurately focus a single beam of electromagnetic energy so that it would activate only one die at a time.

In accordance with an aspect of the present invention, no one of the electromagnetic beams 124, 134, 144 individually couples or delivers sufficient energy to the selected die 22 to activate that die. The energy of at least two beams is required to activate the die. Preferably, all three beams 124, 134, 144 are required to overlap at least partially to couple sufficient to energy to the die 22. to activate that die.

In particular, the first electromagnetic energy source 122 produces a first beam of electromagnetic energy 124 directed toward the portion of the selected die 22 containing the conductive loop 42 (Figure 2), 62 (Figure 5), or 72 (Figure 7). The first beam of electromagnetic energy 124 does not provide sufficient energy to the conductor loop 42. 62, or 72 to cause sufficient current to flow through the conductor loop 42. 62. or 72 to activate the circuitry 30 of the die 22.

The second electromagnetic energy source 132 produces a second beam of electromagnetic energy 134, which is directed toward the same portion of the selected die 22 to which the first beam 124 was directed. The second beam of electromagnetic energy 134 also does not itself provide sufficient energy to the conductor loop 42, 62, or 72 to cause enough current to flow to activate the circuitry 30. The second electromagnetic energy source 132 directs the second electromagnetic beam 134 so that as much as possible the second electromagnetic beam 134 overlaps the first electromagnetic beam 132. The second electromagnetic beam 134 is in phase with the first electromagnetic beam 132 at the point at which the beams 124, 134 impact the conductor loop 42, 62, or 72, so that the energies of the two electromagnetic beams 132, 134 are mutually in phase and reinforce each other.

In certain instahces, the two electromagnetic beams 124, 134 may together couple sufficient energy to the conductor loop 42, 62, or 72 to at least equal the energy required to activate the circuitry 30 by causing sufficient current to flow in the conductor loop 42, 62, or 72 to activate the circuitry 30. in those circumstances, the two beams 124, 134 may be focused with sufficient precision that the region of overlap between the two beams on the die 22 is sufficiently precise that only one die at a time is activated.

The third electromagnetic energy source 144 produces a third beam of electromagnetic energy 144, which is also directed toward the same portion of the selected die 22 to which the first and second electromagnetic beams 132. 134 are directed. Thus, to the extent possible, the three beams of electromagnetic energy 124, 134. 144 are directed to overlap at least partially on the die 22 at the point at which the conductor loop 42, 62, or 72 is located. The third beam of electromagnetic energy 144 also does not itself supply to the conductor loop 42, 62, or 72 sufficient energy to cause sufficient current to flow through that conductor loop to activate the circuitry 30. The third beam 144 is in phase with the first and second beams 124, 134 at the conductor loop 42, 62, or 72 so that the third beam 144 reinforces the first and second beams 124, 134.

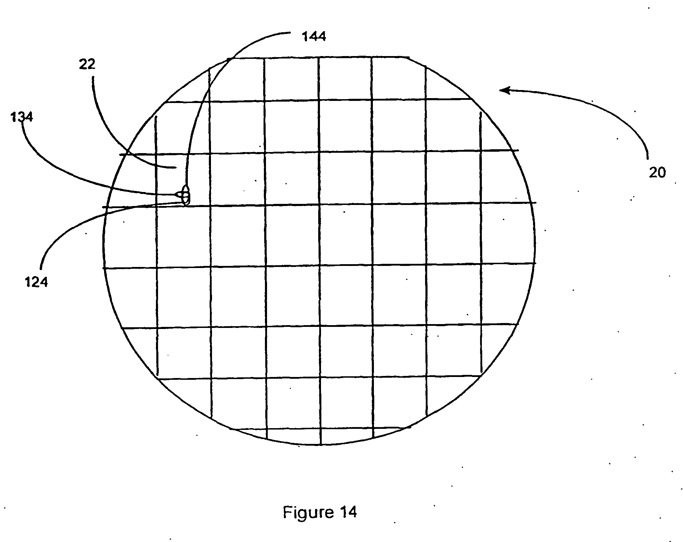

Figure 14 illustrates the three beams 124, 134, 144 overlapping on the die 22 of the wafer 20. The combined energy of the three beams 124, 134. 144 at the conductor loop 42, 62, or 72 is sufficient to cause a current to flow through the conductor loop to activate the circuitry 30 for testing.

Using multiple beams, each of which individually does not have sufficient energy to excite a particular die, allows the beams to be adjusted so that they overlap only on the selected die. Using three beams allow a greater degree of precision in creating the area of beam overlap on the die 22.

The electromagnetic energy sources 122, 132, 142 are controlled by a control computer 160 (Figure 13). The control computer 160 may be a programmed general-purpose computer. Control lines 162, 163, 164 connect the control computer 160 to the electromagnetic energy sources 122, 132, 142, respectively.

The control signals supplied by the control computer 160 to the electromagnetic energy sources 122, 132, 142 cause the electromagnetic energy sources to focus their beams of electromagnetic energy 124, 134, 144 to overlap on the exact portion of the circuitry 30 on the die 22 containing the conductor loop 42 (Figure 2), the spiral conductor 62 (Figure 6), or the multi-layer spiral conductor 72 (Figures 7 -10).

The control signals supplied by the control computer 160 to the energy sources 122, 132, 142 also control the phase of the energy beams 124, 134, 144. As noted above, it is desirable for the electromagnetic beams 124. 134, 144 to be mutually in phase at the point at which the beams 124, 134, 144 impact the conductor loops 42, 62, or 72, so that the energies of the three beams 124, 134, 144 reinforce each other.

The electromagnetic energy sources 122, 132, 142 may include modulated electron guns, lasers, microwave generators, or radio frequency signal generators.

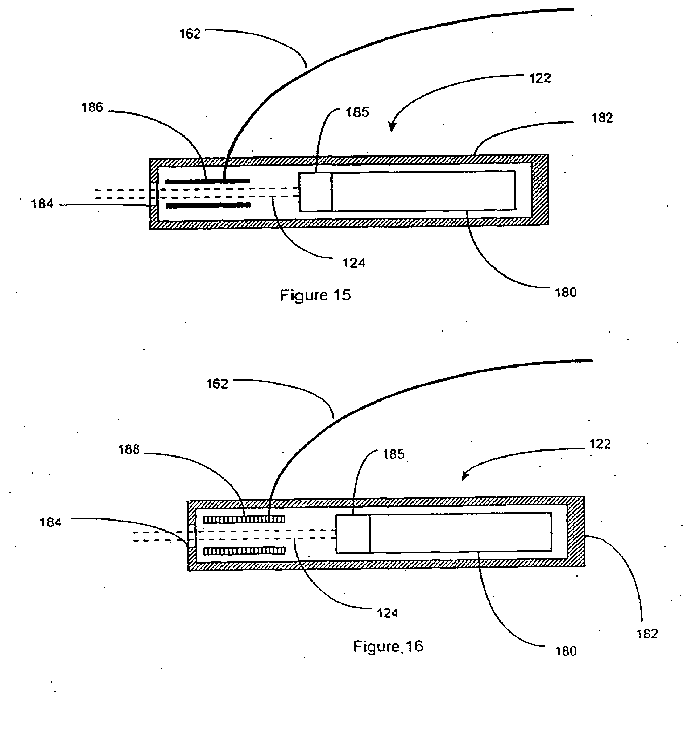

An exemplary electromagnetic energy source 122 incorporating an electron gun 180 is shown in Figure 15. The electron gun 180 is enclosed within a housing 182. An opening 184 in one end of the housing 182 permits passage of the electron beam 124 emitted from the electron gun 180. A set of deflector plates 186 controls the direction of the beam from the electron gun 180.

The electron beam 124 is modulated in intensity at a predetermined modulation frequency by an intensity modulator 185. In this manner, the electron beam 124 behaves as a time varying current. The intensity modulation of an electron beam such as the beam 124 is well known, and commonly used in applications such as cathode ray tubes (CRTs).

The time-varying electron beam 124 sets up a time varying electric field along the beam. This time-varying electric field surrounding the electron beam 124 is so closely associated with the electron beam 124 that it may be thought of as virtually equivalent to the electron beam. For the purposes hereof, then, the time-varying electron beam 124 functions as a beam of electromagnetic energy. Thus, when this time-varying beam impacts the conductor loop 42, 62, or 72, the conductor loop is presented with a time-varying electric field. The frequency and phase of the modulation applied to the electron beam becomes the frequency and phase of the equivalent electromagnetic "beam" propagating with the electron beam 124.

The modulation frequency applied by the modulator 185 to develop the modulated electron beam 124 may be selected from a wide range, depending on the specific needs. For example, a modulation frequency of several Hertz may be chosen.

The direction of the beam 124 may be controlled by electrically charging two sets of deflection plates 186, as is understood by those familiar with the art. The charging of the deflector plates 186 to control the direction of the beam 124 is determined by instructions transmitted by the control computer 160 through the control line 162 (Figure 13). Controlling the direction of the beam 124 allows the beam to be directed at the selected die 22. The construction and operation of electron guns are well understood in the art. Electron guns are used in CRT's and other applications.

If, to scan the entire wafer 20, the electron beam 124 must be moved through a range of movement greater than can be provided using the deflection plates 186, the entire electromagnetic energy source 122 may be movable. The electromagnetic source 122 may be moved using one or more electric motors (not shown). The electric motors may also be directed by control signals generated by the control computer 160 and directed through the control line 162.

An alternative embodiment for the electromagnetic energy source 122 is shown in Figure 16. The electromagnetic energy source 122 shown in Figure 16 also includes an electron gun 180 enclosed in a housing 182. The electron gun 180 modulates the intensity of the electron beam 124. An opening 184 in one end of housing allows passage of the electron beam 124 generated by the electron gun 180. The direction of the beam 124 may be controlled by deflection coils 188. As is understood in the art, controlling the current flowing through the deflection coils 188 creates a magnetic field that adjusts direction of the electron beam 124 passing by those coils 188.

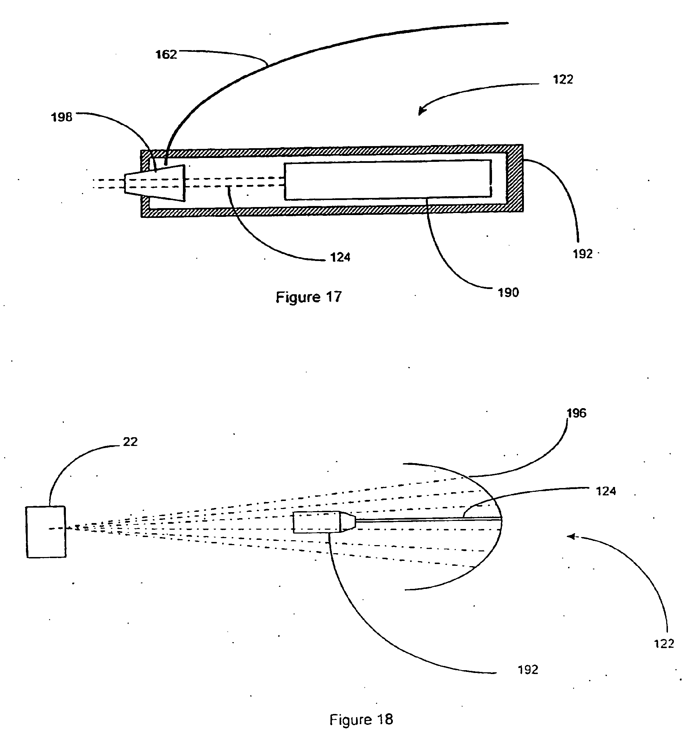

Shown in Figure 17 is yet another embodiment for the electromagnetic energy source 122. A radio-frequency source 190 generates a beam 124 of RF energy. The RF beam is directed by the wave guide 198. Extraneous RF energy may be contained by a housing 192. An opening through the end of housing holds the wave guide 198. A variety of RF sources are available and familiar to those skilled in the art.

In certain circumstances it may be difficult to adequately focus the RF beam 124 directly using only the wave guide 198. In such circumstances, the beam 124 emerging from the wave guide 198 may be reflected on a concave mirror or reflector 196, as shown in Figure 18. The concave reflector 196 is shaped to focus RF energy emerging from the wave guide 198 at a particular focal point. Adjusting the position and direction of the reflector 196 allows that focal point of the reflector 196 to be positioned at the proper place on the die 22.

The test system 110 of Figure 13 selectively activates each individual die 22 on the wafer 20. The control computer 160 causes the electromagnetic energy sources 122, 132, 142 to selectively direct or focus their beams 124, 134, 144 on particular die of the wafer.

A probe does not need to physically contact the die to individually activate the die. The dies are activated wirelessly by directing the electromagnetic beams 124, 134, 144 to the selected die. Many dies on the wafer may be rapidly tested in succession. Unlike prior testing methods, a probe does not need to be physical moved from die to die. The electromagnetic beams 124, 134, 144 may be rapidly moved to focus on different dies. When the electromagnetic beams 124, 134, 144 are electron beams, movement of the beams 124, 134, 144 may require only changing the charge on the deflector plates 186 or the current in the deflector coils 188.

The test system 110 may be used in methods for testing many different die designs with minimal changes to the test system 110. New probes do not need to be designed for each new die design. A different die design may be activated for testing by simply changing the pattern followed by the electromagnetic energy beams 124, 134, 144. The pattern followed by the electromagnetic energy beams 124. 134, 144 may be changed by changing the control signals to the electromagnetic energy sources 122, 132. 142. Therefore, a change in the pattern followed by the electromagnetic energy beams 124, 134, 144 may be implemented by simply changing the programming of the control computer 160.

Because different physical probes do not need to be attached to the system 110 when a new die design is to be tested, the system 110 may be rapidly changed to enable various methods for testing different die designs.

Referring again to Figure 13, a wireless test probe 200 in the test system 110 detects the response signal emitted by the radiating element 90 of the die 22. For example, the wireless test probe 200 may detect the magnetic field created by the current flowing through the second conductor loop 92 of the radiating element 90.

The test probe 200 may be placed near the wafer 20 when the wafer 20 is mounted on the test bed 112. The signals detected by the probe 200 are directed from the probe 200 to the control computer 160 through a probe connection 202. The control computer 160 analyzes the signals received by the probe 200. This analysis can be helpful in determining that the circuitry 30 of the die 22 is operating appropriately when the die is activated. The specific analysis procedure performed by the control computer depends on the particular feature to be analyzed. Those familiar with the testing microelectronic circuitry are familiar with such analysis programs.

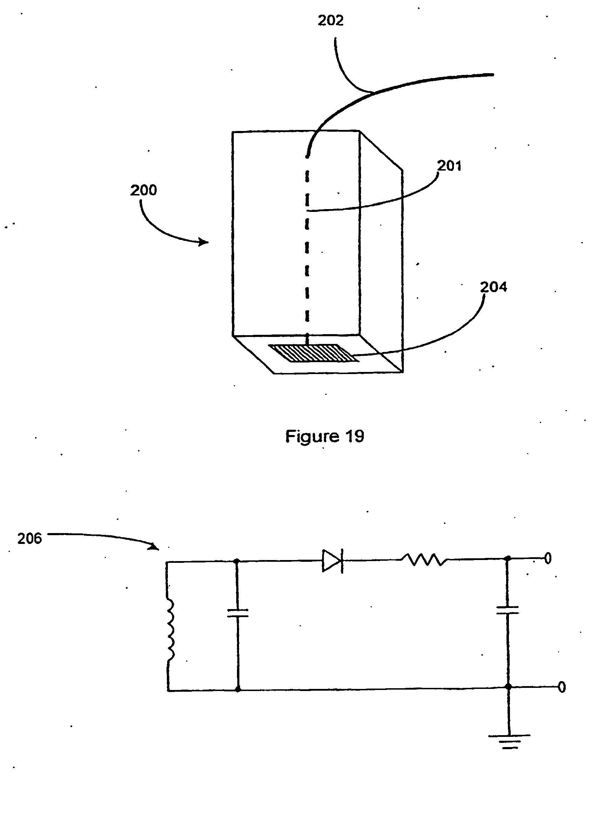

Referring now to Figure 19, the test probe 200 includes an electromagnetic receiver 204. The electromagnetic receiver 204 may be included on the bottom of the test probe 200 so that the receiver 204 may be brought into close proximity with the wafer 20. A probe conductor 201 conducts the detected signal from the receiver 204 to the probe connection 202.

In a simplified embodiment, those skilled in the art will recognize that electrical currents in the radiating element 90 may be inductively coupled to the receiver 204. Similarly, voltages in the radiating element 90 may be capacitively coupled to the receiver 204.

These electrical principles permit information to be transferred from the radiating element 90 (Figure 11) to the test probe 200 wirelessly. Such wireless communication of information from the radiating element 90 eliminates the need to physically contact the die 22 of the wafer 20 to determine if the die is operating property upon being activated by the electromagnetic beams 124, 134, 144.

The receiver 204 may include a simple detector comprising a conductor loop similar to the conductor loops 42, 62, or 72. Such conductor loops detect radiation emitted from a radiating element such as the conductor loop 92 shown in Figure 11.

When the radiating element 90 of the die 22 includes an RF transmitter, the receiver 204 on the test probe 200 detects the RF signal emitted by the radiating element 90. The receiver 204 demodulates or decodes the information from the detected RF signal.

The receiver 204 may include a simple detectorldemodulator 206 (Figure 20) for receiving RF signals from the radiating element 90 of the die 22. The detector/demodulator 206 of the receiver 204 is tuned to the frequency of the oscillator of the radiating element 90 of the die 22. The detector/demodulator 206 shown in Figure 20 and other detector/demodulators are also well understood by those skilled in the art.

How closely the receiver 204 of the probe 200 must be placed to particular die 22 of the wafer 20 is a function of the distance over which the receiver 204 may accurately detect and decode signals transmitted by the radiating element 90. The probe 200 preferably may be placed close enough to the die 20 so that the receiver 204 detects the radiation emitted by the radiating element 90 without antenna or amplification devices.

For the receiver 204 of the test probe 200 to accurately receive radio frequency signals emitted by the radiating element 90, the test probe 200 may be positioned so that the receiver 204 is within 10 cm of the die 22. Preferably, the receiver 204 of the test probe 200 is placed within three cm of the die 22.

The wireless test probe 200 enhances the wireless testability of the die 22 of the wafer 20. Physical contact with the die 22 is not required to detect the test response signals emitted by the radiating element 90 of the die 22. The control computer 160 may control the movement of the probe 200 so that it follows the activation beams 124, 134, 144 over the wafer 20.

Wireless receipt of the test response signals from the die 22 allows the individual die 22 of a wafer 20 to be tested quickly. In addition, the pattern followed by the test probe 200 may be changed by changing the programming of the control computer 160. No changes to the hardware of the test system 110 are required to test different die designs. This lack of hardware changes allows the test system 110 to be quickly adapted to enable various methods for testing a variety of different die designs.

Having been provided with the above description, those having skill in the art will be able to design a variety of specific embodiments and implementations to the invention. For example, other forms of generating beams of electromagnetic energy may be developed. In addition, a variety of the implementations are possible for activating the circuitry on the particular die to which the electromagnetic energy is directed. Furthermore, various implementations for controlling the electromagnetic energy sources will be apparent to those skilled in the art. Therefore, the above description is intended to be exemplary, and not limiting.

## Claims

1. A method of wirelessly activating a selected die on a wafer having a plurality of dies, wherein said selected die is activated by being impacted by electromagnetic energy having at least a first energy level, the method comprising:
- directing, a first beam of electromagnetic energy toward said selected die, wherein said first beam of electromagnetic energy impacts said selected die with less than said first energy level;
- directing a second beam of electromagnetic energy toward said selected die, wherein said second beam of electromagnetic energy impacts said selected die with less than said first energy level; and
- directing said first and second beams of electromagnetic energy so that said first and second beams of electromagnetic energy at least partially overlap on said selected die, wherein said first and second beams together impact said selected die with an energy.level at least equal to said first energy level.

2. The method of claim 1, wherein said steps of directing said first and second-beams of electromagnetic energy comprise directing said first and second beams of electromagnetic energy to a conductive loop on said selected die so that a current is generated in said conductive loop.

3. The method of claim 1, wherein:
- the first beam of electromagnetic energy is modulated at a predetermined frequency by a first intensity modulator such that a time-varying electric field surrounds said first beam; and
- the second beam of electromagnetic energy is modulated at a predetermined frequency by a second intensity modulator such that a time-varying electric field surrounds said second beam.

4. The method of claim 3, wherein said steps of directing said first and second beams of electromagnetic energy comprise directing said first and second beams with electrically charged deflection plates.

5. The method of claim 1, wherein said selected die radiates an electromagnetic signal when it is activated by being impacted by electromagnetic radiation having an energy level at least equal to said first energy level, and wherein said method additionally comprises detecting said radiated electromagnetic signal.

6. The method of claim 1, wherein said first and second beams of electromagnetic energy are mutually coherent at the point at which they contact the die.

7. A method of wirelessly activating a selected die on a wafer having a plurality of dies wherein said selected die is activated by being impacted by electromagnetic energy having at least a first energy level, the method comprising:
- directing a first beam of electromagnetic energy toward said selected die, wherein said first beam of electromagnetic energy impacts said selected die with less than said first energy level;
- directing a second beam of electromagnetic energy toward said selected die, wherein said second beam of electromagnetic energy impacts said selected die with less than said first energy level; and
- directing a third beam of electromagnetic energy toward said selected die, wherein said third beam of electromagnetic energy impacts said selected die with less than said first energy level; and
- directing said first, second and third beams of electromagnetic energy so that said first, second and third beams of electromagnetic energy at least partially overlap on said selected die, wherein said first, second and third beams together impact said selected die with an energy level at least equal to said first energy level.

## Patentansprüche

1. Verfahren zum drahtlosen Aktivieren einer ausgewählten elektrischen Komponente auf einer Platte mit einer Vielzahl elektrischer Komponenten, wobei die ausgewählte elektrische Komponente durch Beaufschlagung mit elektromagnetischer Energie mit zumindest einem ersten Energie-Level aktiviert wird, mit folgenden Verfahrensschritten:
- Richten eines ersten Strahles elektromagnetischer Energie auf die ausgewählte elektrische Komponente, wobei der erste Strahl elektromagnetischer Energie die ausgewählte elektrische Komponente mit weniger als dem ersten Energie-Level beaufschlagt;
- Richten eines zweiten Strahles elektromagnetischer Energie auf die ausgewählte elektrische Komponente, wobei der zweite Strahl elektromagnetischer Energie die ausgewählte elektrische Komponente mit weniger als dem ersten Energie-Level beaufschlagt; und
- Ausrichten des ersten und zweiten Strahls elektromagnetischer Energie derart, dass der erste und zweite Strahl zumindest teilweise im Bereich der ausgewählten elektrischen Komponente überlappen, wobei der erste und zweite Strahl zusammen die ausgewählte elektrische Komponente mit einem Energie-Level beaufschlagen, welches zumindest dem ersten Energie-Level entspricht.

2. Verfahren nach Anspruch 1, **dadurch gekennzeichnet, dass** die Verfahrensschritte des Richtens des ersten und zweiten Strahls elektromagnetischer Energie das Richten des ersten und zweiten Strahls elektromagnetischer Energie auf einen leitfähigen Kreis der ausgewählten elektrischen Komponente beinhaltet, wodurch ein Strom in dem leitfähigen Kreis erzeugt wird.

3. Verfahren nach Anspruch 1, **dadurch gekennzeichnet, dass**
- der erste Strahl elektromagnetischer Energie durch einen ersten Intensitäts-Modulator derart mit einer vorbestimmten Frequenz moduliert wird, dass ein zeitveränderliches elektrisches Feld den ersten Strahl umgibt; und
- der zweite Strahl elektromagnetischer Energie durch einen zweiten Intensitäts-Modulator derart mit einer vorbestimmten Frequenz moduliert wird, dass ein zeitveränderliches elektrisches Feld den zweiten Strahl umgibt.

4. Verfahren nach Anspruch 3, **dadurch gekennzeichnet, dass** die Verfahrensschritte eines Richtens des ersten und zweiten Strahls elektromagnetischer Energie ein Richten, Ausrichten oder Umlenken des ersten und zweiten Strahls mit elektrisch aufgeladenen Ablenk-Platten beinhaltet.

5. Verfahren nach Anspruch 1, **dadurch gekennzeichnet, dass** die ausgewählte elektrische Komponente ein elektromagnetisches Signal abstrahlt, wenn diese durch Beaufschlagung mit elektromagnetischer Strahlung mit einem Energie-Level aktiviert wird, welches zumindest dem ersten Energie-Level entspricht, und wobei das Verfahren weiterhin ein Detektieren des abgestrahlten elektromagnetischen Signals beinhaltet.

6. Verfahren nach Anspruch 1, **dadurch gekennzeichnet, dass** der erste Strahl und der zweite Strahl elektromagnetischer Energie an dem Ort, an dem diese die ausgewählte elektrische Komponente beaufschlagen oder kontaktieren, zueinander kohärent sind.

7. Verfahren zum drahtlosen Aktivieren einer ausgewählten elektrischen Komponente auf einer Platte mit einer Vielzahl elektrischen Komponenten, wobei die ausgewählte elektrische Komponente durch Beaufschlagung mit elektromagnetischer Energie mit einem ersten Energie-Level aktiviert wird, mit folgenden Verfahrensschritten:
- Richten eines ersten Strahls elektromagnetischer Energie auf die ausgewählte elektrische Komponente, wobei der erste Strahl elektromagnetischer Energie die ausgewählte elektrische Komponente mit weniger als dem ersten Energie-Level beaufschlagt;
- Richten eines zweiten Strahls elektromagnetischer Energie auf die ausgewählte elektrische Komponente, wobei der zweite Strahl elektromagnetischer Energie die ausgewählte elektrische Komponente mit weniger als dem ersten Energie-Level beaufschlagt; und
- Richten eines dritten Strahls elektromagnetischer Energie auf die ausgewählte elektrische Komponente, wobei der dritte Strahl elektromagnetischer Energie die ausgewählte elektrische Komponente mit weniger als dem ersten Energie-Level beaufschlagt; und
- Ausrichten des ersten Strahls, zweiten Strahls und dritten Strahls elektromagnetischer Energie derart, dass der erste, zweite und dritte Strahl elektromagnetischer Energie zumindest teilweise auf der ausgewählten elektrischen Komponente überlappen, wobei der erste, zweite und dritte Strahl zusammen die ausgewählte elektrische Komponente mit einem Energie-Level beaufschlagen, welches zumindest dem ersten Energie-Level entspricht.

## Revendications

1. Procédé d'activation sans fil d'une matrice sélectionnée sur une plaquette ayant une pluralité de matrices, dans lequel ladite matrice sélectionnée est activée en subissant un impact d'une énergie électromagnétique ayant au moins un premier niveau d'énergie, le procédé consistant à :
- diriger un premier faisceau d'énergie électromagnétique vers ladite matrice sélectionnée, dans lequel ledit premier faisceau d'énergie électromagnétique a un impact sur ladite matrice sélectionnée avec moins que ledit premier niveau d'énergie ;
- diriger un deuxième faisceau d'énergie électromagnétique vers ladite matrice sélectionnée, dans lequel ledit deuxième faisceau d'énergie électromagnétique a un impact sur ladite matrice sélectionnée avec moins que ledit premier niveau d'énergie ; et
- diriger lesdits premier et deuxième faisceaux d'énergie électromagnétique de manière que lesdits premier et deuxième faisceaux d'énergie électromagnétique se recouvrent au moins partiellement sur ladite matrice sélectionnée, dans lequel lesdits premier et deuxième faisceaux d'énergie électromagnétique ont ensemble un impact sur ladite matrice sélectionnée avec un niveau d'énergie au moins égal audit premier niveau d'énergie.

2. Procédé selon la revendication 1, dans lequel lesdites étapes consistant à diriger lesdits premier et deuxième faisceaux d'énergie électromagnétique consistent à diriger lesdits premier et deuxième faisceaux d'énergie électromagnétique vers une boucle conductrice sur ladite matrice sélectionnée de manière qu'un courant soit généré dans ladite boucle conductrice.

3. Procédé selon la revendication 1, dans lequel :
- le premier faisceau d'énergie électromagnétique est modulé à une fréquence prédéterminée par un premier modulateur d'intensité de manière qu'un champ électrique variable dans le temps entoure ledit premier faisceau ; et
- le deuxième faisceau d'énergie électromagnétique est modulé à une fréquence prédéterminée par un deuxième modulateur d'intensité de manière qu'un champ électrique variable dans le temps entoure ledit deuxième faisceau.

4. Procédé selon la revendication 3, dans lequel lesdites étapes consistant à diriger lesdits premier et deuxième faisceaux d'énergie électromagnétique consistent à diriger lesdits premier et deuxième faisceaux avec des plaques de déviation chargées électriquement.

5. Procédé selon la revendication 1, dans lequel ladite matrice sélectionnée rayonne un signal électromagnétique quand elle est activée en subissant l'impact d'un rayonnement électromagnétique ayant un niveau d'énergie au moins égal au premier niveau d'énergie et dans lequel ledit procédé consiste en outre à détecter ledit signal électromagnétique rayonné.

6. Procédé selon la revendication 1, dans lequel lesdits premier et deuxième faisceaux d'énergie électromagnétique sont mutuellement cohérents au point au niveau duquel ils entrent en contact avec la matrice.

7. Procédé d'activation sans fil d'une matrice sélectionnée sur une plaquette ayant une pluralité de matrices, dans lequel ladite matrice sélectionnée est activée en subissant un impact d'une énergie électromagnétique ayant au moins un premier niveau d'énergie, le procédé consistant à :
- diriger un premier faisceau d'énergie électromagnétique vers ladite matrice sélectionnée, dans lequel ledit premier faisceau d'énergie électromagnétique a un impact sur ladite matrice sélectionnée avec moins que ledit premier niveau d'énergie ;
- diriger un deuxième faisceau d'énergie électromagnétique vers ladite matrice sélectionnée, dans lequel ledit deuxième faisceau d'énergie électromagnétique a un impact sur ladite matrice sélectionnée avec moins que ledit premier niveau d'énergie ; et
- diriger un troisième faisceau d'énergie électromagnétique vers ladite matrice sélectionnée, dans lequel ledit deuxième faisceau d'énergie électromagnétique a un impact sur ladite matrice sélectionnée avec moins que ledit premier niveau d'énergie ; et
- diriger lesdits premier, deuxième et troisième faisceaux d'énergie électromagnétique de manière que lesdits premier, deuxième et troisième faisceaux d'énergie électromagnétique se recouvrent au moins partiellement sur ladite matrice sélectionnée, dans lequel lesdits premier, deuxième et troisième faisceaux d'énergie électromagnétique ont ensemble un impact sur ladite matrice sélectionnée avec un niveau d'énergie au moins égal audit premier niveau d'énergie.
